(19) Europäisches Patentamt
European Patent Office
Office européen des brevets

(11) **EP 2 500 746 B1**

(12) **EUROPÄISCHE PATENTSCHRIFT**

(45) Veröffentlichungstag und Bekanntmachung des Hinweises auf die Patenterteilung:
**30.10.2013 Patentblatt 2013/44**

(51) Int Cl.:
*G01S 7/481* (2006.01)   *G01S 17/02* (2006.01)
*G01S 17/48* (2006.01)   *H01L 31/02* (2006.01)

(21) Anmeldenummer: **11158160.9**

(22) Anmeldetag: **14.03.2011**

(54) **Optoelektronisches Bauelement und Lichttaster mit einem solchen**

Optoelectronic component and photoelectric switch with such a component

Composant optoélectronique et commutateur photoélectrique comprenant ce composant

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**19.09.2012 Patentblatt 2012/38**

(73) Patentinhaber: **SICK AG**
**79183 Waldkirch (DE)**

(72) Erfinder: **Merettig, Gerhard**
**79350, Sexau (DE)**

(74) Vertreter: **Ludewigt, Christoph**
**Sick AG**
**Intellectual Property**
**Erwin-Sick-Strasse 1**
**79183 Waldkirch (DE)**

(56) Entgegenhaltungen:
**EP-A2- 0 206 840   DE-A1- 1 514 344**
**DE-A1- 10 061 649**

• **FORTUNATO E ET AL: "New ultra-light flexible large area thin film position sensitive detector based on amorphous silicon", JOURNAL OF NON-CRYSTALLINE SOLIDS, NORTH-HOLLAND PHYSICS PUBLISHING. AMSTERDAM, NL, Bd. 266-269, 1. Mai 2000 (2000-05-01), Seiten 1213-1217, XP004198731, ISSN: 0022-3093, DOI: DOI:10.1016/S0022-3093(99)00926-6**

**Beschreibung**

Die Erfindung betrifft ein optoelektronisches Bauelement zur Positionsbestimmung eines auftreffenden Lichtstrahls in einer Längsrichtung und einen Lichttaster, der nach dem Triangulationsprinzip arbeitet, mit einem solchen Bauelement.

Lichttaster, die nach dem Triangulationsprinzip arbeiten, weisen einen Lichtsender zur Erzeugung eines Sendelichtstrahls auf, sowie eine Lichtempfangsoptik mit einem Lichtempfänger, der den an einem Objekt reflektierten Lichtstrahl detektiert. Der Lichtempfänger ist dabei ortsauflösend ausgebildet, wobei der Auftreffpunkt des Lichtstrahls auf dem Empfänger abhängig ist vom Abstand des Objektes zum Lichttaster. Der Lichtempfänger muss dabei nur in einer Richtung ortsauflösend ausgebildet sein.

Für derartige Lichttaster werden bisher drei verschiedene Lichtempfängerarten eingesetzt.

In einer ersten Alternative wird ein sogenanntes Doppelelement als Empfänger eingesetzt, bei dem es sich im Wesentlichen um zwei nebeneinander positionierte Photodioden handelt. Ein solches Doppelelement hat allerdings verschiedene Nachteile. So kann mit einem Doppelelement nur festgestellt werden, ob das Objekt diesseits oder jenseits eines bestimmten Abstands sich befindet, also ob die Reflexion des Lichtstrahls entweder auf dem ersten oder zweiten Element  detektiert wird. Das ist für eine Vielzahl von Anwendungen jedoch ausreichend, allerdings kann der Detektionsabstand nur mechanisch eingestellt werden, indem beispielsweise ein zusätzlicher Spiegel den Lichtreflex auf den Empfänger lenkt und der Spiegel dann einstellbar verschwenkbar ist. Alternativ könnte auch die Empfangsoptik verschiebbar ausgebildet werden. Beides bedeutet einen hohen mechanischen Aufwand und einen zusätzlichen Bauraum, der in Subminiaturgeräten nicht zur Verfügung steht. Die Ausführungsform mit verschiebbarer Empfangsoptik ist weiterhin nachteilig, denn dann kann eine Empfangslinse nicht in eine Frontscheibe integriert werden. Des Weiteren sind mechanische Verstellungen von Sendelinse, Empfangsoptik oder Spiegel bei sehr kleinen Geräten schwer zu realisieren und erzeugen eine Detektionsverschlechterung. Zudem wirken sich gerade bei kleinen Geräten mechanische Instabilitäten besonders stark auf die Einstellung des Objektabstandes aus.

In einer zweiten Alternative ist der Lichtempfänger als Photodiodenarray, beispielsweise als Diodenzeile ausgebildet. Photodiodenzeilen mit entsprechender Auswerteeinheit für jede der vielen Photodioden benötigen einen entsprechenden Bauraum, der bei sehr kleinen Sensoren nicht zur Verfügung steht. Zur Bauraumersparnis muss dann auf Zusatzelemente, wie beispielsweise eine spezielle Auswertung zur Störunterdrückung oder dergleichen verzichtet werden, um den Lichtempfänger mit der entsprechenden Auswertung in dem zur Verfügung stehenden Platz unterbringen zu können.

Des Weiteren sind sogenannte PSD-Elemente (Position sensitive device) bekannt, die jedoch den Nachteil haben, dass sie nur eine schlechte Trennung von Hintergrund zu Vordergrund liefern, also der genaue Grenzabstand ab dem der Hintergrund, der nicht detektiert werden soll, beginnt, nicht ausreichend scharf festgelegt werden kann. Des Weiteren haben PSD-Elemente den Nachteil einer großen Schwarz-Weiß-Verschiebung. Mit Schwarz-Weiß-Verschiebung ist die Verschiebung des Detektionsabstandes gemeint, der auftritt, wenn einerseits ein helles weißes Objekt detektiert wird und andererseits ein dunkles schwarzes Objekt  detektiert wird. Der detektierte Abstand ist beim PSD in gewissem Maße also abhängig von der Intensität des auftreffenden Lichtes.

Ein solches PSD-Element ist aus der EP 0 206 840 A2 bekannt, die einen Triangulationtaster zeigt, der eine Photodiodenstruktur und Kontaktierungen an die Photodiodenstruktur aufweist. Die Photodiodenstruktur ist auf der Lichtempfangsseite mit einer lichtdurchlässigen und elektrisch isolierenden Schutzschicht bedeckt, die nur an den beiden Stirnrändern jeweils einen Streifen freilässt. Über diese Streifen erfolgt die Kontaktierung mit einer Elektrode, wobei ein Teil der Elektrode sich zusätzlich noch über die lichtdurchlässige Schutzschicht erstreckt. Dadurch wird ein Teil der Photodiodenstruktur abgeschattet, um die Photodiodenstruktur vor ungewolltem Lichteinfall abzuschirmen und das Schrotrauschen ("shot noise") zu reduzieren. Die Schutzschicht ist elektrisch isolierend, damit die bekannten Eigenschaften des PSD-Elements zur Positionsbestimmung durch die zu den Elektroden abfließenden Photoströme nicht beeinflusst werden.

Ausgehend von diesem Stand der Technik ist es Aufgabe der Erfindung, ein verbessertes optoelektronisches Bauelement zur Positionsbestimmung eines auftreffenden Lichtstrahls bereit zu stellen, sowie einen Lichttaster mit einem solchen optoelektronischen Bauelement bereit zu stellen, der die vorgenannten Nachteile nicht mehr aufweist und insbesondere extrem klein aufgebaut werden kann bei reduzierten Kosten.

Diese Aufgabe wird gelöst durch ein optoelektronisches Bauelement mit den Merkmalen des Anspruchs 1 und einen Lichttaster mit den Merkmalen des Anspruchs 8.

Das erfindungsgemäße optoelektronische Bauelement zur Positionsbestimmung eines auftreffenden Lichtstrahls in einer Längsrichtung weist eine Photodiodenstruktur mit Flachseiten, Längsseiten und zwei gegenüberliegende Stirnseiten auf. Eine der Flachseiten weist eine erste niederohmige Kontaktschicht auf für einen ersten elektrischen Kontakt, beispielsweise eine Kathode, und entlang der Stirnseiten sind zweite niederohmige Kontaktschichten vorgesehen, die die Anoden bilden. Erfindungsgemäß erstreckt sich nun wenigstens eine der zweiten Kontaktschichten nicht nur entlang der Stirnseite, sondern auch über Teilabschnitte entlang einer ersten und zweiten Längsseite, die sich gegenüberliegen, wobei auch die Teilabschnitte mit der Photodiodenstruktur Kontakt haben.

Dadurch wird zwar die Linearität über die gesamte Länge des PSD-Elements aufgehoben, allerdings andererseits die PSD-Eigenschaften auf einen Teilbereich des PSD-Elements reduziert, nämlich auf den Bereich, der zwischen der anderen zweiten Kontaktschicht und den Enden der Teilabschnitte liegt. Damit wird quasi das Lichtempfangselement funktionsmäßig geteilt, so dass ein Teil des Elements als Standardphotodiode fungiert, nämlich der Teil, über den sich die Teilabschnitte erstrecken, und der Rest sich als "normales" PSD-Element verhält. Dadurch wird erreicht, dass der PSD-Übergang nur in dem Bereich zwischen den niederohmigen Anbindungen vorhanden ist. Als Folge davon, bildet sich in diesem Bereich dann ein steilerer Übergang, als wenn dieser sich über das gesamte Lichtempfangselement erstrecken würde. Dadurch ist eine genauere Einstellmöglichkeit eines Grenzabstands gegeben, wenn das erfindungsgemäße optoelektronische Bauelement in einem Lichttaster eingesetzt wird, mit dem in erster Linie Objekte nur innerhalb eines Grenzabstands detektiert werden sollen und Objekte im Hintergrund nicht detektiert werden sollen. Dabei handelt es sich um einen sogenannten Lichttaster mit Hintergrundausblendung oder auch kurz HGA-Taster genannt.

Der steilere Übergangsbereich des erfindungsgemäßen Bauelements erzeugt eine genaue Einstellmöglichkeit des Grenzabstands und ermöglicht auch eine kleinere Hysterese bzw. kleinere Schwarz-Weiß-Verschiebungen, wobei die Vorteile eines PSD-Elements, nämlich die Möglichkeit, sehr kleinen Bauraum vorzusehen und kostengünstig zu sein, erhalten bleiben.

Für eine genaue Einstellung des Grenzabstands ist es von Vorteil, wenn die zweiten Kontaktschichten symmetrisch zur Längsachse ausgebildet sind und sich die Teilabschnitte an sich gegenüberliegenden Längsseiten gleich weit erstrecken.

Der PSD-Übergangsbereich in dem erfindungsgemäßen optoelektronischen Bauelement ist besonders gut definiert, wenn die Teilabschnitte an ihrem stirnseitig abgewandten Ende miteinander verbunden sind. Dann herrscht nämlich über die gesamte Breite (quer zur Längsrichtung) des Bauelements das gleiche Potential, also die Äquipotentiallinien verlaufen im Wesentlichen parallel zur Stirnseite.

In Weiterbildung der Erfindung kann die Verbindung der Teilabschnitte die lichtempfindliche Schicht von einer Längsseite zur anderen durchsetzen, also unterbrechen.

In Weiterbildung der Erfindung sind zwischen den niederohmigen und parallel zu den Stirnseiten verlaufenden Kontaktschichten weitere niederohmige parallel zu den Stirnseiten verlaufende Trennschichten, die sich von einer Längsseite zur anderen erstrecken, vorgesehen. Diese Trennschichten haben keine Kontaktierung zur Anode oder Kathode. Insbesondere, wenn diese Trennschichten sich nicht nur von einer Längsseite zur anderen erstrecken, sondern auch sich entlang Trennschichtteilabschnitten entlang der Längsseiten erstrecken, weist das erfindungsgemäße optoelektronische Bauelement quasi mehrere PSD-Übergänge auf, so dass insgesamt so etwas ähnliches wie stufenförmige Übergänge erzeugbar sind. Dadurch können mehrere Bereiche definiert werden, in denen eine verbesserte Einstellung von Tastabständen möglich ist.

Bevorzugt wird das erfindungsgemäße optoelektronische Bauelement in einem Lichttaster eingesetzt, der nach dem Triangulationsprinzip arbeitet. Mittels einer Auswerteeinheit kann der Abstand eines Objekts vom Lichttaster aus dem Auftreffpunkt des vom Objekt reflektierten Lichtstrahls auf das Lichtempfangselement, also das optoelektronische Bauelement, bestimmt werden, wie dies von an sich bekannten Triangulationstastern bekannt ist. Das besondere Einsatzgebiet dieses erfindungsgemäßen Lichttasters liegt in der Anwendung als HGA-Taster, also in der Vorgabe eines Grenzabstands, über den hinaus der Hintergrund definiert ist und sämtliche Signale von Objekten im Hintergund ignoriert werden, und nur dann ein Ausgangssignal an einen entsprechenden Ausgang gegeben wird, wenn ein Objekt sich innerhalb des Grenzabstands befindet.

Im Folgenden wird die Erfindung anhand von Ausführungsbeispielen unter Bezugnahme auf die Zeichnung im Einzelnen erläutert. In der Zeichnung zeigen:

Figur 1      ein PSD-Element nach dem Stand der Technik in der Seitenansicht;

Figur 2      das PSD-Element aus Figur 1 in der Draufsicht auf die lichtempfindliche Schicht;

Figur 3      eine Kennlinie des PSD-Elements aus Figur 1 und 2, bei dem die Stromverteilung auf die beiden Anoden aufgetragen ist gegenüber dem Auftreffpunkt eines Lichtflecks auf dem PSD-Element;

Figur 4      eine schematische Darstellung eines erfindungsgemäßen Lichttasters;

Figur 5      eine Kennlinie des Lichttasters nach Figur 4, bei dem die Auftreffposition eines Lichtempfangsstrahls auf das Licht-empfangselement aufgetragen ist gegenüber der Tastweite;

Figur 6      eine schematische Darstellung einer Seitenansicht eines erfindungs-gemäßen Bauelements;

Figur 7      eine Draufsicht auf die Lichtempfangsseite des Bauelements nach Figur 6;

Figur 8      eine Kennlinie wie in Figur 3 des erfindungs-

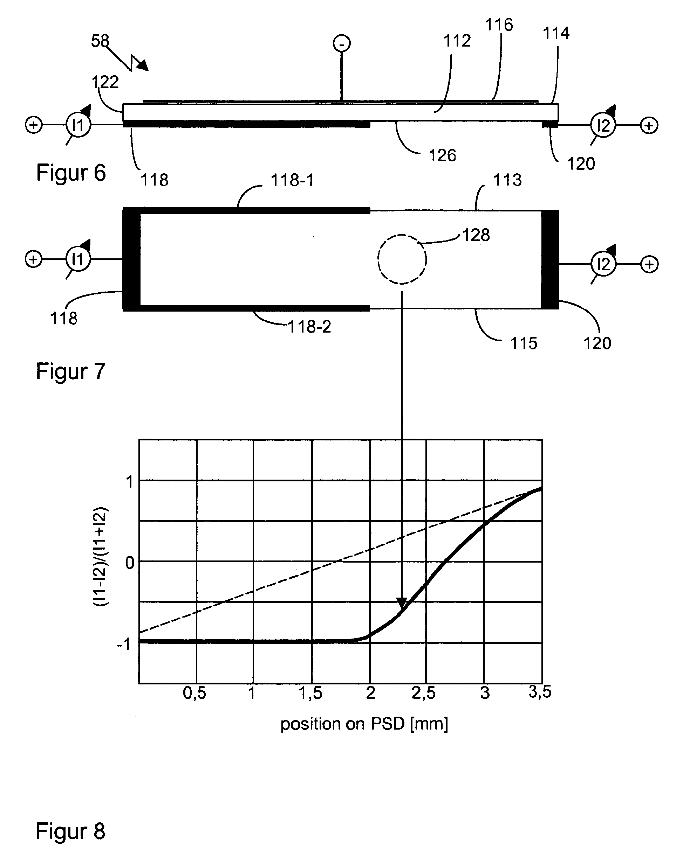

gemäßen Bauelements aus Figur 6 und 7;

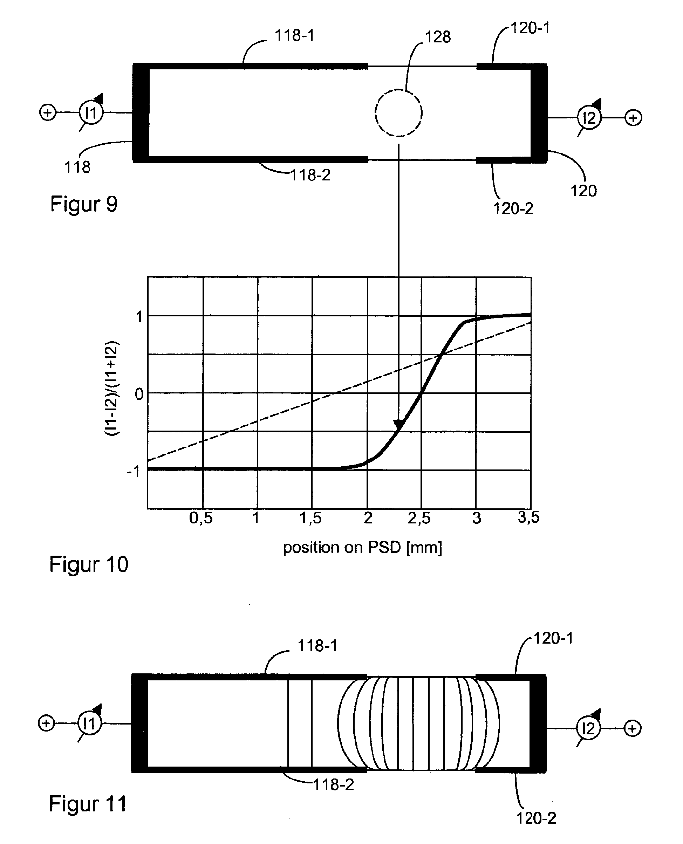

Figur 9     eine Ansicht wie Figur 7 eines weiteren Ausführungsbeispiels des erfindungsgemäßen Bauelements;

Figur 10    eine Darstellung der Kennlinie der Ausführungsform aus Figur 9;

Figur 11    Darstellungen des PSD-Übergangs mit Hilfe von Äquipotentiallinien eines erfindungsgemäßen Bauelements der Ausführungsform nach Figur 9;

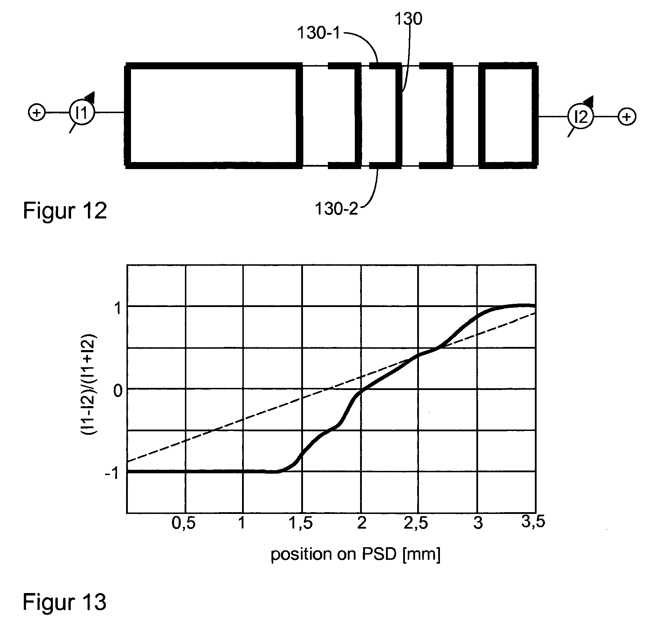

Figur 12    eine weitere Ausführungsform des erfindungsgemäßen Bauelements und

Figur 13    eine dementsprechende Kennlinie in schematischer Darstellung.

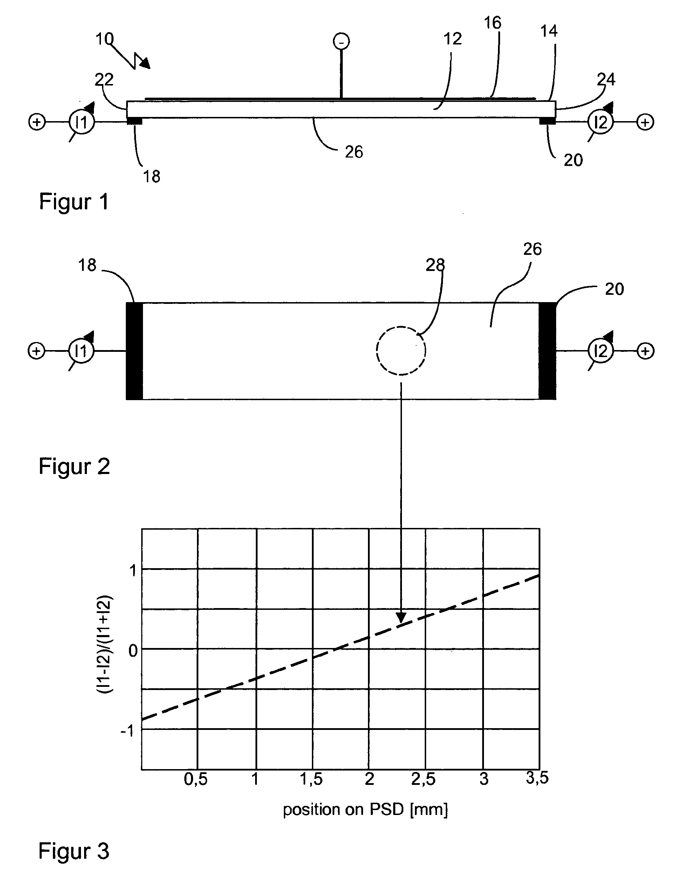

Die Figuren 1 bis 3 zeigen ein übliches eindimensionales PSD-Element 10, wie dies an sich aus dem Stand der Technik bekannt ist. Die Erläuterungen zu den Figuren 1 bis 3 dienen in erster Linie zur Begriffsbestimmung, um die Erfindung und insbesondere die Unterschiede zum bisherigen Stand der Technik besser verstehen zu können.

Das PSD-Element 10 ist ein optoelektronisches Bauteil, das eine flächige PN-Struktur oder PIN-Struktur wie bei einer Photodiode aufweist, die in Figur 1 mit dem Bezugszeichen 12 gekennzeichnet ist. Eine der dotierten Schichten, in der Regel die N-dotierte Schicht ist flächig an einer ersten Flachseite 14 an eine niederohmige erste Kontaktschicht 16 angebunden und die andere dotierte Schicht ist mit wenigstens zwei niederohmigen zweiten Kontaktschichten 18 und 20 angebunden, die sich entlang der Stirnseiten 22 und 24 erstrecken. Wird eine Lichtempfangsseite 26 belichtet mit einem Lichtspot 28, so entsteht im Bereich der Belichtung ein Photostrom, der je nach Lichtposition in Längsrichtung des PSD-Elements 10 gesehen in einem bestimmten Verhältnis über die an den Stirnseiten liegenden niederohmigen Kontaktierungen 18 und 20 als Strom I1 und I2 abfließt. Die Anteile I1 und I2 des Stromes werden bestimmt durch den Widerstand, der zwischen Lichtspot und der jeweiligen Kontaktierung 18 bzw. 20 vorhanden ist.

Eine übliche Auswerteformel für die beiden Ströme I1 und I2 ist gegeben durch

$$x = (I1 - I2) / (I1 + I2).$$

Bei x = -1 trifft der Lichtspot auf das ganz an der in Figur 2 linken Seite gelegene Ende des PSD-Elements 10, bei x = 0 in der Mitte des Bauteils und bei x = +1 ganz rechts.

Die Kennlinie in Figur 3 zeigt den entsprechenden linearen Verlauf über das gesamte PSD-Element 10. Zum Zwecke der besseren Illustrierung sind konkrete Maßangaben gemacht, die typischerweise vorhanden sind. Die Länge der Lichtempfangsseite 26 des PSD-Elements beträgt 3, 5 mm und der Durchmesser des Lichtspots 28 0, 5 mm. Zur besseren Illustrierung werden diese Maße auch verwendet bei der nachfolgenden Erläuterung der Ausführungsformen des erfindungsgemäßen optoelektronischen Bauelements.

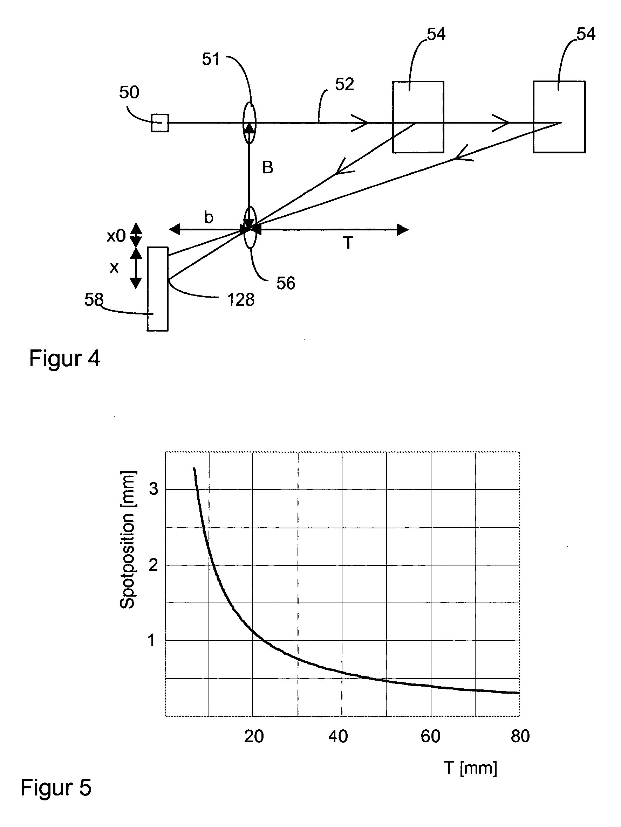

Figur 4 zeigt eine schematische Darstellung eines erfindungsgemäßen Lichttasters. Der Lichttaster weist einen Lichtsender 50 mit einer Sendeoptik 51 auf, mit der ein Lichtstrahl 52 erzeugt wird. Dieser Lichtstrahl 52 trifft auf ein Objekt 54, das sich in einem Abstand T (Tastweite) befindet. Der an dem Objekt 54 reflektierte Lichtstrahl 52 wird von einer Empfangsoptik 56 aufgenommen und auf ein erfindungsgemäßes optoelektronisches Bauelement 58, das im Nachfolgenden erläutert wird, geführt. In einer solchen Triangulationsanordnung ist die Position (Spotposition 128) des empfangenen Lichts abhängig von der Tastweite T entsprechend der Kennlinie aus Figur 5. Mit dem als Basisabstand B definierten Abstand zwischen Sendeoptik 51 und Empfangsoptik 56 und dem Abstand b des Lichtempfängers 58 von der Empfangsoptik 56 und Abstand x0 als vertikaler Abstand der oberen Kante des Lichtempfangselements 58 von der Mitte der Empfangsoptik 56 ergibt sich mit den Strahlensätzen B / T = (x + x0) / b oder umgeformt: x = (B * b) / T - x0. Aus der Kennlinie aus Figur 5 ist erkennbar, dass wenn man einen Einstellbereich zwischen 20 und 80 mm benötigt, dass man dann für die Position des Lichtspots 28 weniger als 1 mm des Lichtempfangselements 58 benötigt, um den kompletten Detektionsbereich von 20 bis 80 mm abzudecken. Dabei bedeutet Einstellbereich der Bereich, in dem eine Trennung von Vorder- und Hintergrund eingestellt werden kann. Im Vordergrund soll ein Objekt erkannt werden, also ein Signal ausgegeben werden, dass ein Objekt vorhanden ist, und im Hintergrund sollen die Objekte nicht zu einem Signal führen.

Um genau in diesem kritischen Bereich, die Position des Lichtspots 28 verbessert bestimmen zu können, ist das optoelektronische Bauelement 58 erfindungsgemäß wie folgt ausgebildet:

In einer ersten Ausführungsform, die in den Figuren 6, 7 und 8 dargestellt ist, weist das erfindungsgemäße optoelektronische Bauelement 58 die gleiche Photodiodenstruktur 112 wie das PSD-Element 10 nach dem Stand der Technik auf. Ebenso ist eine erste niederohmige Kontaktschicht 116 vorgesehen an einer ersten Flachseite 114. Des Weiteren sind entlang der Stirnseiten zweite niederohmige Kontaktschichten 118 und 120 vorgesehen, über die jeweils die Ströme I1 und I2 abfließen. Erfindungsgemäß ist jetzt aber die eine der zweiten Kontaktschichten 118 so ausgebildet, dass diese sich nicht nur entlang der Stirnseite 122 erstreckt, sondern auch über Teilabschnitte 118-1 und 118-2 entlang einer ersten und zweiten Längsseite 113 und 115.

Das bewirkt, dass der PSD-Übergang wie er für ein PSD-Element nach dem Stand der Technik in Figur 3 dargestellt ist, sich jetzt im Wesentlichen auf den Bereich zwischen den beiden niederohmigen Kontaktschichten 118 und 120 reduziert, so dass dieser PSD-Übergang jetzt in den Bereichen zwischen 2 mm und 3, 5 mm liegt. Fällt der Lichtspot 128 also auf den Übergangsbereich wie in Figur 7 dargestellt, wird eine der Position entsprechende Stromverteilung detektiert, wie sie in der Kennlinie in Figur 8 dargestellt ist. Fällt der Lichtspot 128 in den Bereich zwischen 0 und 2 mm, so wird sämtlicher Strom über die Kontaktschicht 118 abfließen und I2 gleich 0 sein.

Die Figuren 9, 10 und 11 zeigen eine weitere Ausführungsform, bei der auch die andere Kontaktschicht 120 ähnlich ausgebildet ist wie die erste Kontaktschicht 118, also auch Teilabschnitte entlang der Längsseiten aufweist, so dass der PSD-Übergang jetzt eingeschränkt ist auf einen Bereich zwischen 2 und 3 mm. Eine entsprechende Kennlinie für die Stromverteilung in Abhängigkeit der Position des Auftreffpunkts des Lichtspots 128 ist in Figur 10 gezeigt.

Figur 11 zeigt Äquipotentiallinien, die schematisch qualitativ zeigen sollen, in welchem Bereich der PSD-Übergang, also quasi das Potentialgefälle, auftritt und wie die geometrische Form der Kontaktschichten 118 und 120 den Stromfluss I1 und I2 beeinflussen.

Insbesondere an den den Stirnseiten abgewandten Enden der Teilabschnitte 118-1 und 118-2 sowie 120-1 und 120-2 sind diese Äquipotentiallinien etwas gekrümmt, was aber für die Funktionsweise keine Auswirkung hat, denn erstens sind sie zur Längsachse symmetrisch und zweitens ist der Lichtfleck 128 in der Regel so groß, dass die Krümmungen keine größeren Auswirkungen haben. Durch die Größe des Lichtspots 128 ist sowieso eine gewisse "Verschmierung" der eigentlich nur schematisch dargestellten Kennlinien aus Figur 8 und 10 gegeben.

Die Figuren 12 und 13 schließlich zeigen eine weitere Ausführungsform, bei der jetzt die stirnseitig abgewandten Enden der Teilabschnitte 118-1 und 118-2 sowie 120-1 und 120-2 miteinander verbunden sind, also die niederohmige Kontaktschicht sich von der einen Längsseite zur anderen Längsseite erstreckt. Das bedeutet entsprechend dem Äquipotentialbild aus Figur 11, dass die Äquipotentiallinien sich nicht so "ausbauchen" können, wie in Figur 11 dargestellt, also der PSD-Übergang an dieser Stelle schärfer wird. Des Weiteren zeigt dieses Ausführungsbeispiel noch die Möglichkeit, Trennschichten 130 vorzusehen, bei denen es sich um niederohmige Trennschichten handelt, die parallel zu den Stirnseiten verlaufen. Diese Trennschichten sind nicht an ein Potential angebunden und weisen wie die Kontaktschichten 118 und 120 Teilabschnitte 130-1 und 130-2 auf, die sich entlang der Längsseiten über eine gewisse Strecke erstrecken. Auf diese Weise kann der PSD-Übergang in diesem Ausführungsbeispiel zwischen 1, 5 mm und 3 mm in einem gewissen Sinne stufig ausgestaltet werden, so dass an gewissen Stellen eine größere Steilheit der Kennlinie (Figur 13) erzielt werden kann als an anderen Stellen. Dies könnte sinnvoll sein, wenn ein Lichttaster gewünscht ist, der in bestimmten, verschiedenen Abständen schalten soll, also bestimmte Positionen auf dem optoelektronischen Bauelement 58 genauer festgelegt werden können.

## Patentansprüche

1. Optoelektronisches Bauelement zur Positionsbestimmung eines auftreffenden Lichtstrahls in einer Längsachsrichtung, mit einer Photodiodenstruktur (112) mit Flachseiten, Längsseiten und zwei gegenüberliegenden Stirnseiten, mit einer niederohmigen ersten Kontaktschicht (114) an einer ersten Flachseite für einen ersten elektrischen Kontakt an die Photodiodenstruktur (112) und mit wenigstens zwei niederohmigen zweiten Kontaktschichten (118, 120) entlang den Stirnseiten für zweite Kontaktierungen an die Photodiodenstruktur (112), wobei der durch einen auftreffenden Lichtspot (28) erzeugte Photostrom entsprechend der Auftreffposition anteilig zu den zweiten Kontaktierungen (118, 120) abfließt, **dadurch gekennzeichnet, dass** wenigstens eine der zweiten Kontaktschichten (118, 120) sich nicht nur entlang der Stirnseite (122) sondern auch mit Teilabschnitten (118-1 und 118-2) entlang einer ersten und zweiten Längsseite (113 und 115) erstreckt, wobei auch die Teilabschnitte (118-1 und 118-2) mit der Photodiodenstruktur (112) Kontakt haben, wobei die Teilabschnitte einen Teilbereich definieren, in dem das Bauelement als Standardphotodiode fungiert und einen Teilbereich, in dem die Aufteilung des Photostroms erfolgt.

2. Optoelektronisches Bauelement nach Anspruch 1, **dadurch gekennzeichnet, dass** die eine der zweiten Kontaktschichten symmetrisch zur Längsachse ausgebildet ist und die Teilabschnitte an sich gegenüberliegenden Längsseiten gleich erstrecken.

3. Optoelektronisches Bauelement nach Anspruch 2, **dadurch gekennzeichnet, dass** die Teilabschnitte an ihrem stirnseitig abgewandten Ende miteinander verbunden sind.

4. Optoelektronisches Bauelement nach Anspruch 3, **dadurch gekennzeichnet, dass** die Verbindung der Teilabschnitte die lichtempfindliche Schicht von einer Längsseite zur anderen durchsetzt.

5. Optoelektronisches Bauelement nach einem der vorhergehenden Ansprüche, **dadurch gekennzeichnet, dass** wenigstens eine niederohmige, parallel zu den Stirnseiten verlaufende Trennschicht von einer Längsseite zur anderen vorgesehen ist.

**6.** Optoelektronisches Bauelement nach Anspruch 5, **dadurch gekennzeichnet, dass** die Trennschicht die lichtempfindliche Schicht durchsetzt.

**7.** Optoelektronisches Bauelement nach Anspruch 4 oder 5, **dadurch gekennzeichnet, dass** die Trennschicht sich nicht nur von einer Längsseite zur anderen erstreckt, sondern darüber hinaus auch über Trennschichtteilabschnitte entlang der Längsseite erstreckt.

**8.** Lichttaster mit einem Lichtsender und einer Lichtempfangsoptik in einer Triangulationsanordnung und mit einem Lichtempfänger, der ein optoelektronisches Bauelement nach einem der vorhergehenden Ansprüche umfasst und mit einer Auswerteeinheit zur Bestimmung des Abstandes des Objekts vom Lichttaster aus dem Auftreffpunkt des vom Objekt reflektierten Lichtstrahls auf das optoelektronische Bauelement.

**9.** Lichttaster nach dem vorhergehenden Anspruch, **dadurch gekennzeichnet, dass** ein Ausgang vorgesehen ist, an dem ein Ausgangssignal anliegt, wenn ein Objekt sich innerhalb eines bestimmten Abstandsbereichs vom Lichttaster befindet.

**Claims**

**1.** An optoelectronic component for the determination of the position of incidence of an incident light beam along a longitudinal axis having a photodiode structure (112) flat sides, longitudinal sides and two opposed end sides, having a first low ohmic contact layer (114) at a first flat side for a first electric contact to the photodiode structure (112) and having at least two low ohmic contact layers (118, 120) along the end sides for second contacts to the photodiode structure (112), wherein the photo current induced by an incident light spot (28) flows proportional to the two contacts (118, 120) according to its position of impact, **characterized in that** at least one of the second contact layers (118, 120) not only extends along the respective end side (122), but also has part sections (118-1 and 118-2) which extend along a first and a second longitudinal side (113 and 115), wherein the part sections (118-1 and 118-2) have contact with the photodiode structure, wherein the part sections define a sub-region in which the component functions as a standard photodiode and a sub-region in which the division of the photo current takes place.

**2.** Optoelectronic component in accordance with claim 1, wherein the at least one of the second and third contact layers is symmetrical to the longitudinal axis and the part sections extend over the same distance along the opposed longitudinal sides.

**3.** Optoelectronic component in accordance with claim 2, wherein the part sections are connected to one another at their end remote from the end side.

**4.** Optoelectronic component in accordance with claim 3, wherein the connection of the part sections passes through the light sensitive layer from one longitudinal side to the other.

**5.** Optoelectronic component in accordance with any one of the preceding claims, wherein at least one low ohmic dividing layer extending parallel to the end sides is provided from one longitudinal side to the other.

**6.** Optoelectronic component in accordance with claim 5, wherein the dividing layer passes through the light sensitive layer.

**7.** Optoelectronic component in accordance with claim 4 or 5, wherein the dividing layer not only extends from one longitudinal side to the other, but also has part sections extending along longitudinal sides.

**8.** A light sensor having a light transmitter and an optical light reception system in a triangulation arrangement, the light sensor further having an optoelectronic component according to any one of the preceding claims and having an evaluation unit for determining the distance of the object from the light sensor based on a position of incidence of the light beam on the optoelectronic component when reflected by the object.

**9.** A light sensor in accordance with claim 8, wherein an output is provided to which an output signal is applied when an object is located within a specific distance range from the light sensor.

**Revendications**

**1.** Composant optoélectronique pour la détermination de position d'un rayon lumineux incident dans une direction axiale longitudinale, comprenant une structure à photodiode (112) avec des côtés plats, des côtés longitudinaux et deux côtés frontaux opposés, comprenant une première couche de contact (114) à faible résistance sur un premier côté plat pour un premier contact électrique sur la structure à photodiode (112), et comprenant au moins deux secondes couches de contact (118, 120) à faible résistance le long des côtés frontaux pour établir des seconds contacts sur la structure à photodiode (112), dans lequel le courant photoélectrique engendré par une tache lumineuse incidente (28) s'écoule en correspondance de la position d'incidence à proportion vers les seconds contacts (118, 120), **caractérisé en ce que** l'une au moins des secondes couches de contact (118, 120) s'étend non seulement le long du côté frontal (122) mais également avec des tronçons partiels (118-1 et 118-2) le long d'un premier et d'un second côté longitudinal (113 et 115), et les tronçons partiels (118-1 et 118-2) sont également en contact avec la structure à photodiode (112), dans lequel les tronçons partiels définissent une zone partielle dans laquelle le composant fait office de photodiode standard et une zone partielle dans laquelle a lieu la subdivision du courant photoélectrique.

2. Composant optoélectronique selon la revendication 1, **caractérisé en ce que** l'une des secondes couches de contact est réalisée symétrique par rapport à l'axe longitudinal, et les tronçons partiels s'étendent de manière égale sur des côtés longitudinaux opposés.

3. Composant optoélectronique selon la revendication 2, **caractérisé en ce que** les tronçons partiels sont reliés l'un à l'autre à leur extrémité détournée du côté frontal.

4. Composant optoélectronique selon la revendication 3, **caractérisé en ce que** la liaison des tronçons partiels traverse la couche photosensible depuis un côté longitudinal jusqu'à l'autre.

5. Composant optoélectronique selon l'une des revendications précédentes, **caractérisé en ce qu'**il est prévu au moins une couche de séparation à faible résistance, s'étendant parallèlement aux côtés frontaux, depuis un côté longitudinal jusqu'à l'autre.

6. Composant optoélectronique selon la revendication 5, **caractérisé en ce que** la couche de séparation traverse la couche photosensible.

7. Composant optoélectronique selon la revendication 4 ou 5, **caractérisé en ce que** la couche de séparation s'étend non seulement depuis un côté longitudinal jusqu'à l'autre, mais s'étend en outre également le long du côté longitudinal sur des tronçons partiels de la couche de séparation.

8. Détecteur de lumière comprenant un émetteur de lumière et une optique de réception de lumière dans un agencement de triangulation et comprenant un récepteur de lumière, qui inclut un composant optoélectronique selon l'une des revendications précédentes, et comprenant une unité d'évaluation pour déterminer la distance de l'objet depuis le détecteur de lumière à partir du point d'incidence sur le composant optoélectronique du rayon lumineux réfléchi par l'objet.

9. Détecteur de lumière selon la revendication précédente, **caractérisé en ce qu'**il est prévu une sortie à laquelle est appliqué un signal de sortie quand un objet se trouve à l'intérieur d'une zone de distance prédéterminée depuis le détecteur de lumière.

Figur 1

Figur 2

position on PSD [mm]

Figur 3

Figur 4

Figur 5

Figur 6

Figur 7

Figur 8

Figur 9

Figur 10

Figur 11

Figur 12

position on PSD [mm]

Figur 13

# EP 2 500 746 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0206840 A2